# EUROPEAN PATENT APPLICATION

(11) **EP 2 535 119 A2**
(43) Date of publication of application: **19.12.2012**
(21) Application number: 11176773.7
(22) Date of filing: 08.08.2011
(51) Int. Cl.: B06B 1/06

(54) **Transducer module**

(30) Priority: 14.06.2011 TW 100120641
(71) Applicant: Chief Land Electronic Co. Ltd., Wugu Dist., New Taipei City 248 (TW)
(72) Inventor: Chuang, Tsi-Yu, 52142 Changhua County, Xide Village, Beidou Township (TW); Ching, Chia-Nan, 32097 Zhongli City, Taoyuan County (TW); Liu, Bao-Zheng, 31053 Zhudong Township, Hsinchu County (TW)
(74) Representative: Karakatsanis, Georgios

(57) **Abstract**

The present invention is directed to a transducer module including a first transducer (23), a support member (24) and a block member (25). The support member resists or is fixed on a first plate (21) with a first end, and resists or is fixed on the central section of the first transducer with a second end. The block member resists or is fixed on the central section of the first transducer with a first end, and resists or is fixed on a second plate with a second end.

## Description

### BACKGROUND OF THE INVENTION

### 1. FIELD OF THE INVENTION

The present invention generally relates to a transducer, and more particularly to a transducer module utilizing a transducer for generating acoustic effect and haptic feedback.

### 2. DESCRIPTION OF RELATED ART

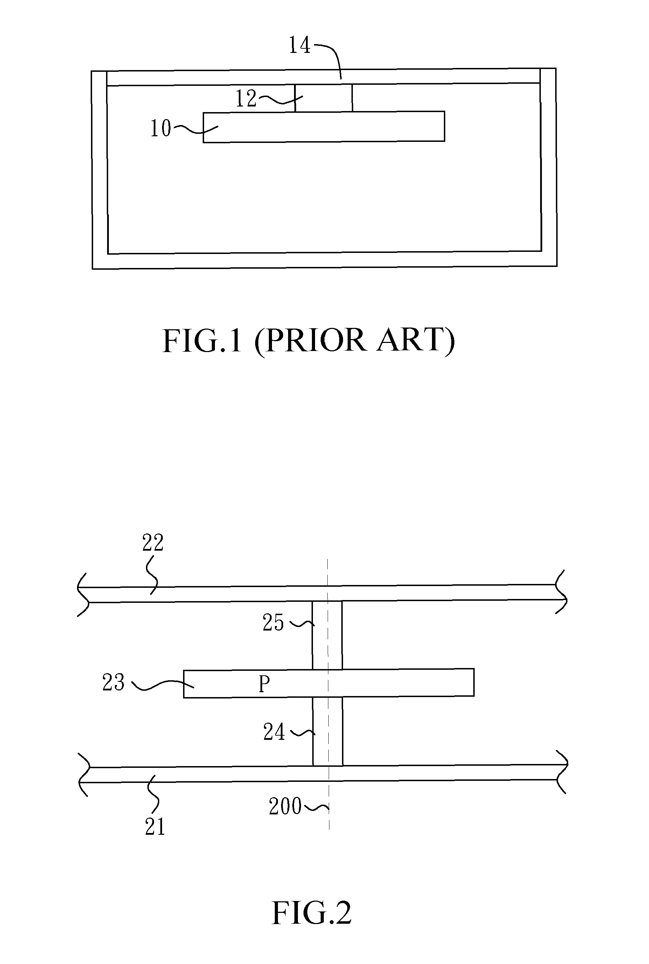

A transducer is a device that converts one type of energy to another. A motor and an electric generator are common electromechanical transducers. The motor converts electric energy to mechanical energy via electromagnetic induction. One type of motor, such as a brush DC motor, a servo motor or a step motor, outputs the mechanical energy in rotational movement; another type of motor, such as a linear motor, converts electric energy directly to linear movement. The electric generator, on the other hand, converts mechanical energy to electric energy. A single-phase generator or a three-phase generator is commonly used in an electric power system. Moreover, the transducer may be implemented by smart material, such as piezoelectric material, electro-active polymer (EAP), shape memory alloy (SMA) or magnetostrictive material. FIG. 1 shows a conventional transducer device, in which a transducer 10, such as a unimorph actuator, bimorph actuator or multimorph actuator, is made of piezoelectric material, which converts electric signals to mechanical movement via converse piezoelectric effect. A common piezoelectric plate has a rectangular shape, a round shape (as of a buzzer) or other shape, which is dependent on actual applications. Considering output strength as a performance index, the multimorph actuator is better than the bimorph actuator, which is further better than the unimorph actuator. Considering cost, as the price of the piezoelectric plate is proportional to its stacked number, the unimorph actuator takes priority if the performance is not strictly required. The structure shown in FIG. 1 is a conventional vibration propagation device, in which the vibration energy of the transducer 10 may be transferred to a top housing 14 via a sticking element 12, thereby generating acoustic effect or haptic feedback. The transducer is ordinarily fixed, by sticking or locking, under the top housing 14 such that the vibration energy may be directly transferred to the top housing 14. However, the commonly used material of the transducer 10 limits the swing amplitude and output strength at endpoints or edges of the transducer 10, such that the transferred vibration energy is restrained, the haptic reaction of the haptic feedback is not evident or the sound pressure level (SPL) generated on the top housing 14 is low. Further, as the transducer 10 in the conventional transducer device is ordinarily stuck to an inner surface of the top housing 14 via the sticking element 12, such assembly procedure consumes substantive time, and the sticking element 12 may peel off after the transducer 10 has been vibrating for a time period.

For the foregoing reasons, a need has arisen to propose a novel transducer module for improving the problem of transducer peeling off, simplifying assembly procedure or increasing inertia strength.

### SUMMARY OF THE INVENTION

In view of the foregoing, it is an object of the embodiment of the present invention to provide a transducer module, which improves acoustic propagation or haptic feedback, the assembly procedure, and durability or reliability over the conventional transducer device.

According to a first embodiment of the present invention, a transducer module includes a first transducer, a support member and a block member. The support member resists or is fixed on a first plate with a first end, and resists or is fixed on a central section of the first transducer with a second end. The block member resists or is fixed on the central section of the first transducer with a first end, and resists or is fixed on a second plate with a second end. Accordingly, the inertia energy of the first transducer is transferred to the second plate via the block member, thereby generating acoustic effect or haptic feedback.

According to a second embodiment of the present invention, in addition to the first transducer, the support member and the block member, the transducer module further includes at least one inertia mass, which is fixed on an outer section of the first transducer for increasing swing amplitude of the outer section of the first transducer and enhancing the transferred inertia strength, or for adjusting resonant mode.

According to a third embodiment of the present invention, in addition to the first transducer, the support member, the block member and the inertia mass, the transducer module further includes at least one second transducer, which is fixed on the inertia mass for enhancing the inertia strength, the haptic feedback and acoustic output, or for adjusting resonant mode.

### BRIEF DESCRIPTION OF THE DRAWINGS

FIG. 1 shows a conventional transducer device;
FIG. 2 shows a cross section of a transducer module according to a first embodiment of the present invention;
FIG. 3 shows coupling the support member and the block member with the first plate and the second plate, respectively, in an embedded scheme;
FIG. 4A and FIG. 4B show modified embodiments of FIG. 2;
FIG. 5A shows a detailed cross section of a first transducer;
FIG. 5B shows a detailed cross section of another first transducer;
FIG. 6A to FIG. 6E show top views of some first transducers 23 of a variety of shapes;
FIG. 7A to FIG. 7D show cross sections of some transducer module according to a second embodiment of the present invention;
FIG. 8A to FIG. 8F show top or bottom views of some first transducers 23 and inertia masses; and
FIG. 9A to FIG. 9C show cross sections of some transducer module according to a third embodiment of the present invention.

### DETAILED DESCRIPTION OF THE INVENTION

FIG. 2 shows a cross section of a transducer module according to a first embodiment of the present invention. In the embodiment, the transducer module is used, but not limited, to convert electric energy to mechanical energy.

The transducer module of the embodiment primarily includes a first transducer (denoted as P) 23, a support member 24 and a block member 25. Specifically, the support member 24 resists or is fixed on a first plate 21 with a first end, and resists or is fixed on a central section of the first transducer 23 with a second end. In this specification, "central section" is referred to a central location or its neighboring locations of an object, and "outer section" is referred to locations other than the central section of an object. The block member 25 resists or is fixed on the center section of the first transducer 23 with a first end, and resists or is fixed on a second plate 22 with a second end. The combination of the first transducer 23, the support member 24 and the block member 25, or the combination of the first plate 21, the first transducer 23, the support member 24 and the block member 25 may be manufactured in a module in order to speed up the assembly.

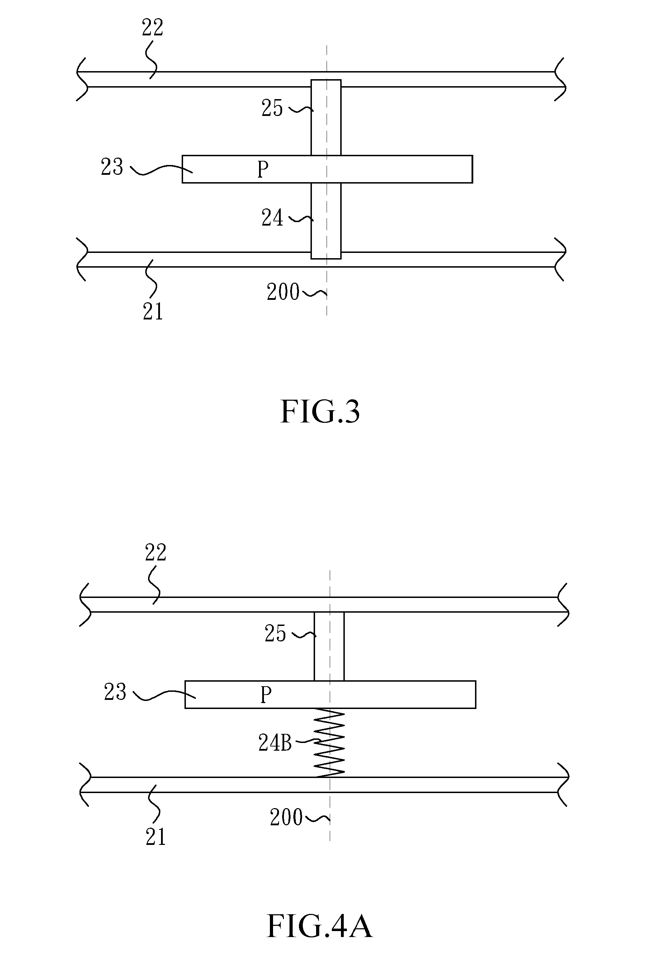

The support member 24 and the first plate 21 may be integrally formed, or be formed separately. As described above, the block member 25 may either resist or be fixed on the second plate 22. The resisting way may facilitate assembly or exchange, and the fixing way may be realized by integrally forming, sticking, locking, screwing or other technique. As shown in FIG. 3, in practice, the block member 25 may resist or be fixed on the second plate 22 in an embedded (or insert) scheme. Likewise, the support member 24 may resist or be fixed on the first plate 21 in an embedded (or insert) scheme.

In the embodiment, the first plate 21 or the second plate 22 may be a screen, a touch panel, a frame, a substrate or a housing. The inertia energy of the first transducer 23 may be transferred to the second plate 22 via the block member 25, thereby generating acoustic effect or haptic feedback. The support member 24 or the block member 25 may be hollow or solid, may have a tube, cylindrical or other shape, and the quantity may be one or greater than one. In one modified embodiment, as shown in FIG. 4A, the support member 24 is a damper 24B, which may be an elastic member such as a spring or an elastic rubber.

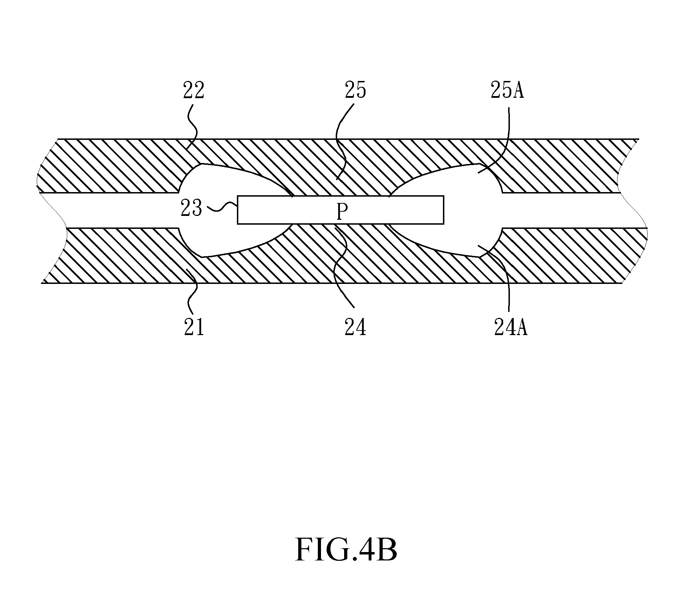

In another modified embodiment, as shown in FIG. 4B, at least one first recess 24A is formed on at least one side of the first plate 21 near the support member 24. The support member 24 and the first recess 24A may be integrally formed when the first plate 21 is being manufactured, or may be formed after the first plate 21 has been manufactured. The support member 24 resists or is fixed on the central section of the first transducer 23, and the quantity and shape of the first recess 24A may be decided according to the shape of the first transducer 23, such that the first transducer 23 may be freely vibrated within the cavity defined by the first recess 24A, thereby saving space and facilitating miniaturization. For example, with respect to a rectangular-shape first transducer 23, two symmetrical first recesses 24A are formed on two sides of the support member 24; with respect to a circular-shape first transducer 23, a ring-shape first recess 24A surrounding the support member 24 is formed.

Likewise, at least one second recess 25A is formed on at least one side of the second plate 22 near the block member 25. The block member 25 and the second recess 25A may be integrally formed when the second plate 22 is being manufactured, or may be formed after the second plate 22 has been manufactured. The block member 25 resists or is fixed on the central section of the first transducer 23, and the quantity and shape of the second recess 25A may be decided according to the shape of the first transducer 23, such that the first transducer 23 may be freely vibrated within the cavity defined by the second recess 25A, thereby saving space and facilitating miniaturization. For example, with respect to a rectangular-shape first transducer 23, two symmetrical second recesses 25A are formed on two sides of the block member 25; with respect to a circular-shape first transducer 23, a ring-shape second recess 25A surrounding the block member 25 is formed.

As exemplified in the figure, the support member 24 and the first plate 21 are integrally formed, and the block member 25 and the second plate 22 are integrally formed. In one exemplary embodiment, the first recess 24A and the second recess 25A as shown in FIG. 4B may be formed by digging technique. The block member 25 and the support member 24 resist or are fixed on the top and bottom surfaces, respectively, of the first transducer 23.

In the embodiment, the first transducer 23 may be made of smart material such as, but not limited to, piezoelectric material (e.g., lead-zirconate-titanate (PZT)), electro-active polymer (EAP), shape memory alloy (SMA) or magnetostrictive material.

According to the transducer module described above, the first transducer 23 moves upward and downward when it is driven by electric energy. As the central section of the first transducer 23 is coupled with the first plate 21 and the second plate 22 via the support member 24 and the block member 25, the up-and-down vibration of the outer section of the first transducer 23 generates inertia strength along a central axis 200 passing through the support member 24 and the block member 25. The inertia strength is transferred to the second plate 22 via the block member 25, and the transferred inertia strength makes the second plate 22 vibrate and push the air, thereby generating acoustic effect or haptic feedback. Compared to the conventional transducer device of FIG. 1, the block member 25 of the present embodiment no longer peels off. Furthermore, the present embodiment provides better acoustic effect or haptic feedback over the conventional transducer device. With respect to the transducer module utilizing the damper 24B (FIG. 4B), the vibration transferred to the support member 24 is absorbed by the damper 24B, and no acoustic effect or haptic feedback is generated on the first plate 21.

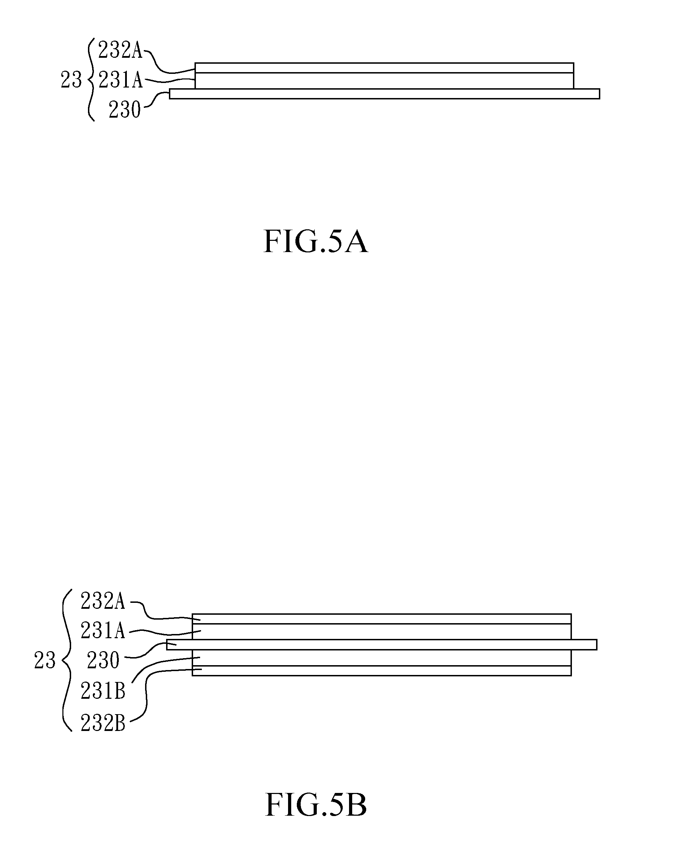

FIG. 5A shows a detailed cross section of a first transducer 23. The first transducer 23 includes a conductive layer 230, a first smart material layer 231A and a first electrode layer 232A. Specifically, the first smart material layer 231A is formed on a top surface of the conductive layer 230, and the first electrode layer 232A is then coated on a top surface of the first smart material layer 231A. The conductive layer 230 and the first electrode layer 232A are used as two electrodes for driving the first smart material layer 231A, and the conductive layer 230, in practice, is made of thin material layer (e.g., an electrode layer) or plate-type material layer (e.g., a metal plate). A conductive layer 230 made of a metal plate can increase toughness and durability of the first transducer 23, and can increase the inertia strength transferred to the second plate 22 for generating acoustic effect or haptic feedback. If single layer of the first smart material layer 231A made of piezoelectric material is used, the first transducer 23 of FIG. 5A may be called a unimorph actuator.

The first transducer 23 may, in practice, use two or more layers of the first smart material layer 231A, therefore resulting in a multi-layer plate.

FIG. 5B shows a detailed cross section of another first transducer 23. The first transducer 23 includes a conductive layer 230, a first smart material layer 231A, a first electrode layer 232A, a second smart material layer 231B and a second electrode layer 232B. Specifically, the first smart material layer 231A is formed on a top surface of the conductive layer 230, and the first electrode layer 232A is then coated on a top surface of the first smart material layer 231A. The second smart material layer 231B is formed on a bottom surface of the conductive layer 230, and the second electrode layer 232B is then coated on a bottom surface of the second smart material layer 231B. The conductive layer 230 is used as a common electrode for the first/second smart material layers 231A/B, and the first/second electrode layers 232A/B are used as two electrodes for driving the first/second smart material layers 231A/B. As two layers (i.e., the first and second smart material layers 231A/B) made of piezoelectric material are used, the first transducer 23 of FIG. 5B may be called a bimorph actuator.

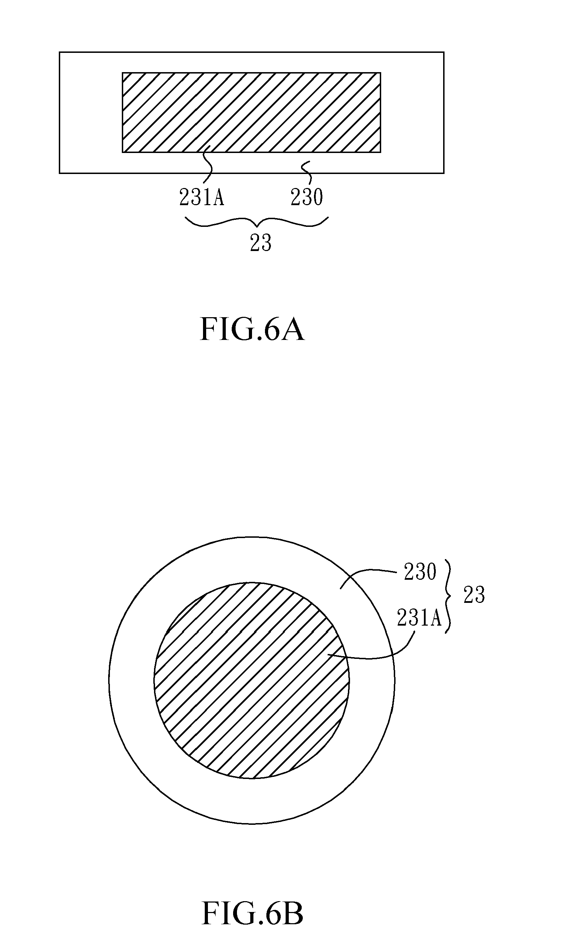

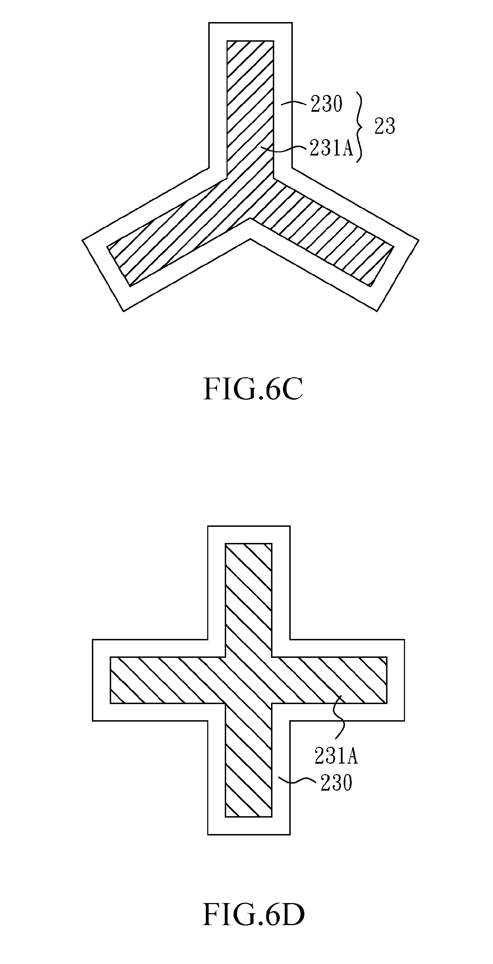

FIG. 6A to FIG. 6E show top views of some first transducers 23 of a variety of shapes. Specifically, FIG. 6A shows a top view of a rectangular-shape first transducer 23, which includes a rectangular-shape conductive layer 230 and a rectangular-shape first smart material layer 231A (with the first electrode layer 232A being omitted for brevity). FIG. 6B shows a top view of a circular-shape first transducer 23, which includes a circular-shape conductive layer 230 and a circular-shape first smart material layer 231A (with the first electrode layer 232A being omitted for brevity). FIG. 6C shows a top view of a tri-fork star-shape first transducer 23, which includes a tri-fork star-shape conductive layer 230 and a tri-fork star-shape first smart material layer 231A (with the first electrode layer 232A being omitted for brevity). FIG. 6D shows a top view of a cross-shape first transducer 23, which includes a cross-shape conductive layer 230 and a cross-shape first smart material layer 231A (with the first electrode layer 232A being omitted for brevity).

The first transducer 23 shown above is exemplified as a unimorph actuator. In practice, a second smart material layer 231B may be added on a bottom surface of the conductive layer 230, and a second electrode layer 232B may be coated on a bottom surface of the second smart material layer 231B, thereby resulting in the bimorph actuator as discussed above.

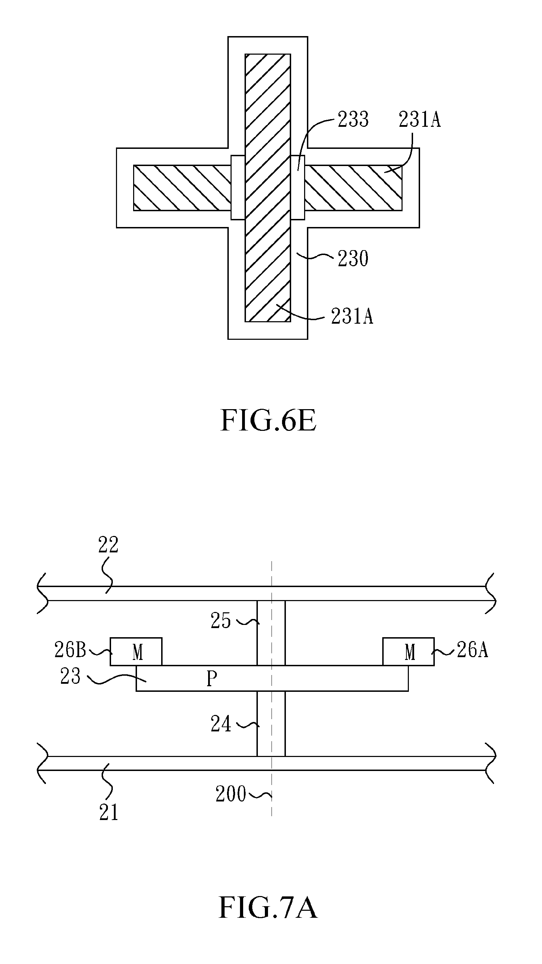

FIG. 6E shows a top view of another cross-shape first transducer 23, which includes two first smart material layers 231A disposed in cruciform on a top surface of a cross-shape conductive layer 230, wherein the two first smart material layers 231A are insulated from each other by an insulator 233, which may be an insulating layer or an insulating member.

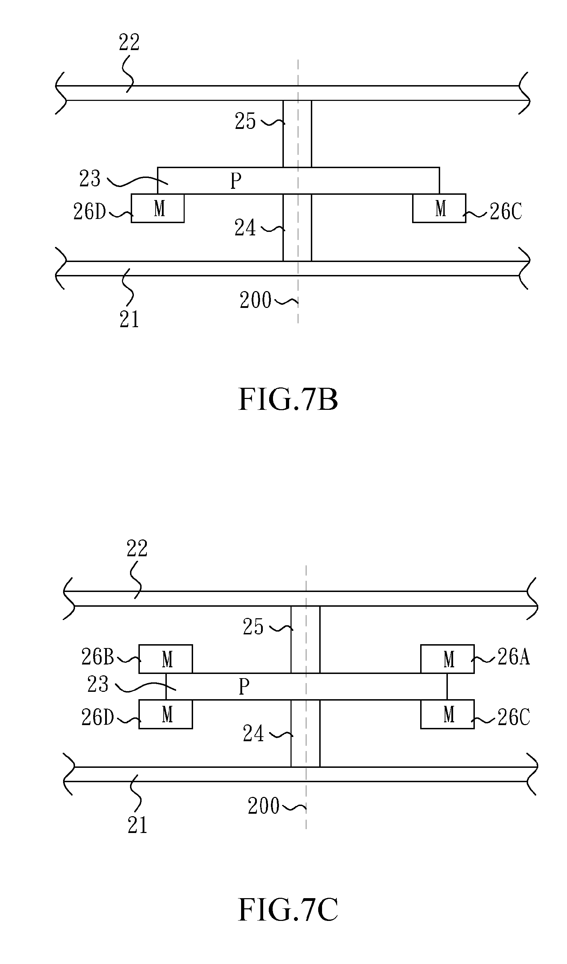

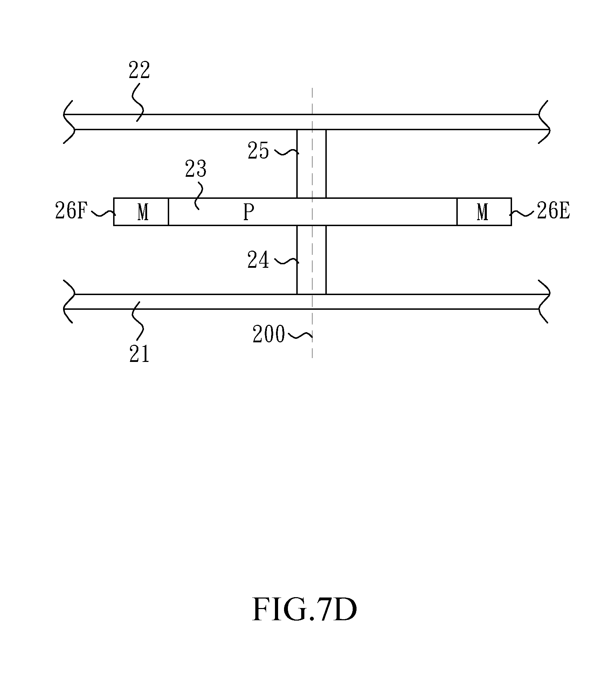

FIG. 7A shows a cross section of a transducer module according to a second embodiment of the present invention. Only the different aspects between the present embodiment and the first embodiment are discussed below. In addition to the first transducer 23, the support member 24 and the block member 25 of the first embodiment, the present embodiment further includes at least one inertia mass fixed on the outer section of the first transducer 23. The inertia masses 26A and 26B, denoted as M in FIG. 7A, are fixed on a top surface of the outer section of the first transducer 23. In this specification, direction "top" is referred to a direction toward the second plate 22, and direction "bottom" is referred to a direction toward the first plate 21. The inertia masses 26A/26B may be made of a variety of materials and shapes, such as high-density material (e.g., metal) or material with high Young's modulus (e.g., zirconium oxide). As shown in FIG. 7B, the inertia masses 26C and 26D are fixed on a bottom surface of the outer section of the first transducer 23. FIG. 7C illustrates that the inertia masses 26A/26B and the inertia masses 26C/26D are fixed on a top surface and a bottom surface of the outer section of the first transducer 23 respectively. As shown in FIG. 7D, the inertia masses 26E and 26F are fixed on edges of the outer section of the first transducer 23. The configurations of FIG. 7A through FIG. 7D may be combined. For example, the inertia masses 26A/26B and the inertia masses 26C/26D of FIG. 7C are fixed on a top surface and a bottom surface of the outer section of the first transducer 23 respectively, and the inertia masses 26E and 26F are further fixed on edges of the outer section of the first transducer 23.

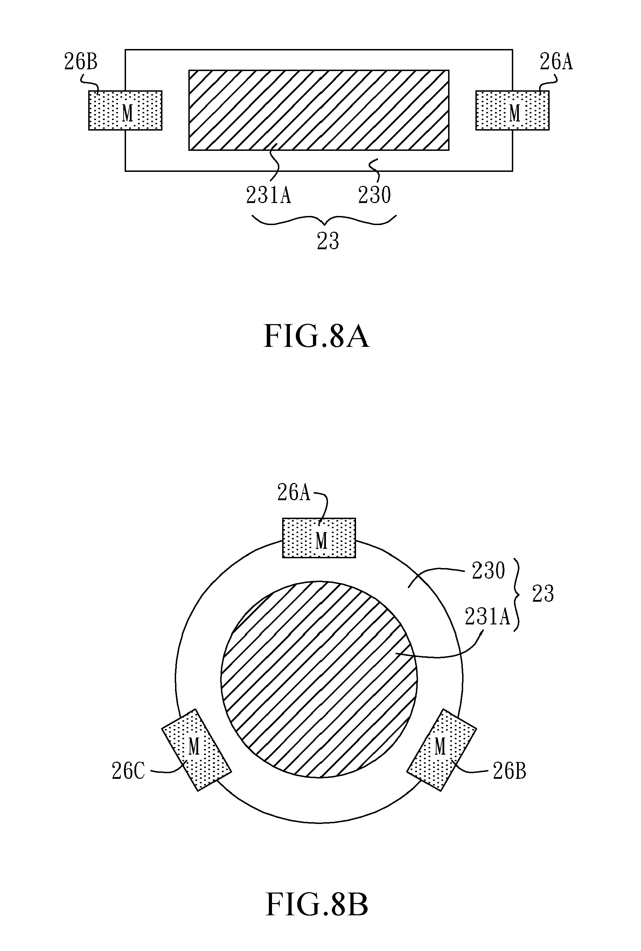

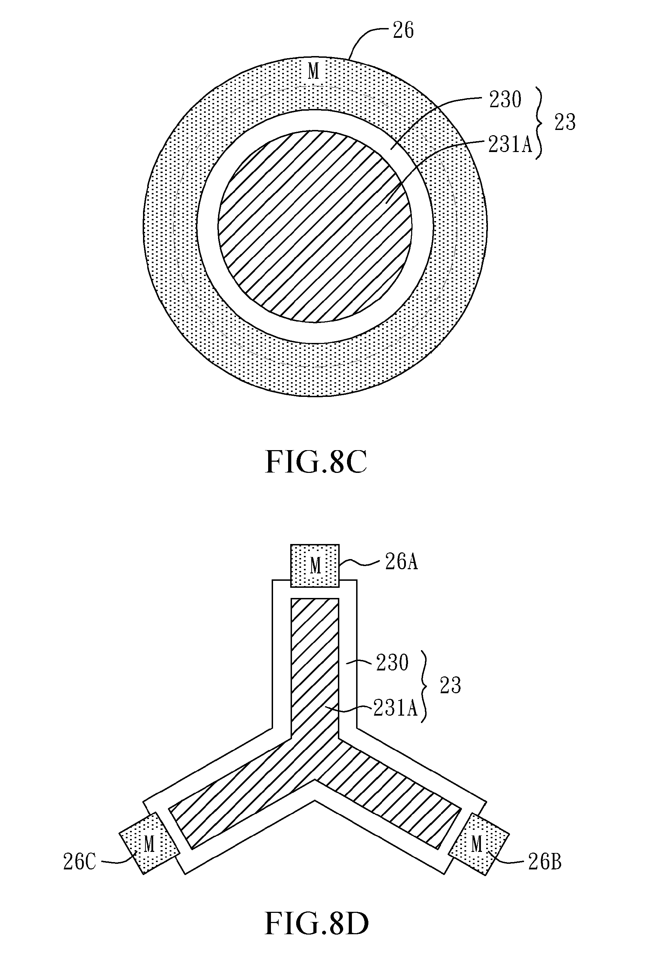

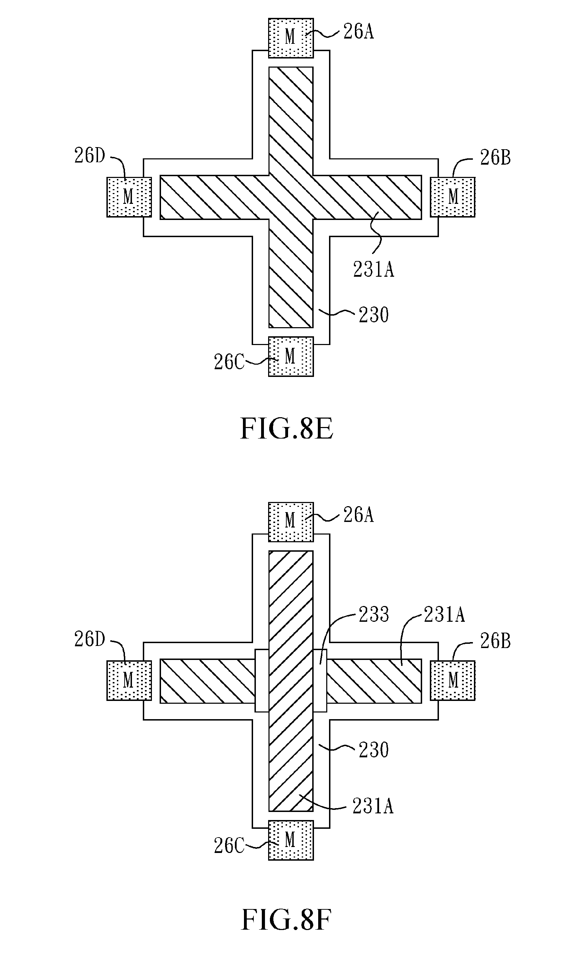

FIG. 8A to FIG. 8F show top or bottom views of some first transducers 23 and inertia masses. Specifically, FIG. 8A shows a top or bottom view of a rectangular-shape first transducer 23 and inertia masses 26A/26B, which include at least a rectangular-shape conductive layer 230 and a rectangular-shape first smart material layer 231A (with the first electrode layer 232A being omitted for brevity). The inertia masses 26A and 26B are disposed on, but not limited to, the outer section of the conductive layer 230. FIG. 8B shows a top or bottom view of a circular-shape first transducer 23 and inertia masses 26A/26B/26C, which include at least one circular-shape conductive layer 230 and a circular-shape first smart material layer 231A (with the first electrode layer 232A being omitted for brevity). The inertia masses 26A/26B/26C are disposed at, but not limited to, equiangular (e.g., 120 degrees) ends of the outer section of the conductive layer 230. Alternatively, the inertia masses may be disposed at equiangular (e.g., 90 degrees) ends of the outer section of the conductive layer 230. FIG. 8C shows a top or bottom view of another circular-shape first transducer 23 and inertia mass 26, wherein the inertia mass 26 is disposed on the entire periphery of the outer section of the conductive layer 230. FIG. 8D shows a top or bottom view of a tri-fork star-shape first transducer 23 and inertia masses 26A/26B/26C, which include at least a tri-fork star-shape conductive layer 230 and a tri-fork star-shape first smart material layer 231A (with the first electrode layer 232A being omitted for brevity). The inertia masses 26A/26B/26C are disposed at, but not limited to, three ends of the outer section of the conductive layer 230. FIG. 8E shows a top or bottom view of a cross-shape first transducer 23 and inertia masses 26A/26B/26C/26D, which include at least a cross-shape conductive layer 230 and a cross-shape first smart material layer 231A (with the first electrode layer 232A being omitted for brevity).

The inertia masses 26A/26B/26C/26D are disposed at, but not limited to, four ends of the outer section of the conductive layer 230.

The first transducer 23 shown above is exemplified as a unimorph actuator. In practice, a second smart material layer 231B may be added on a bottom surface of the conductive layer 230, and a second electrode layer 232B may be coated on a bottom surface of the second smart material layer 231B, thereby resulting in the bimorph actuator as discussed above.

FIG. 8E shows a top or bottom view of another cross-shape first transducer 23 and inertia masses 26A/26B/26C/26D, which include two first smart material layers 231A disposed in cruciform on a top surface of a cross-shape conductive layer 230, wherein the two first smart material layers 231A are insulated from each other by an insulator 233. The inertia masses 26A/26B/26C/26D are disposed at, but not limited to, four ends of the outer section of the conductive layer 230.

According to the transducer module of the second embodiment, the inertia mass can increase the displacement of the outer section of the first transducer 23, or can be used to adjust resonant mode.

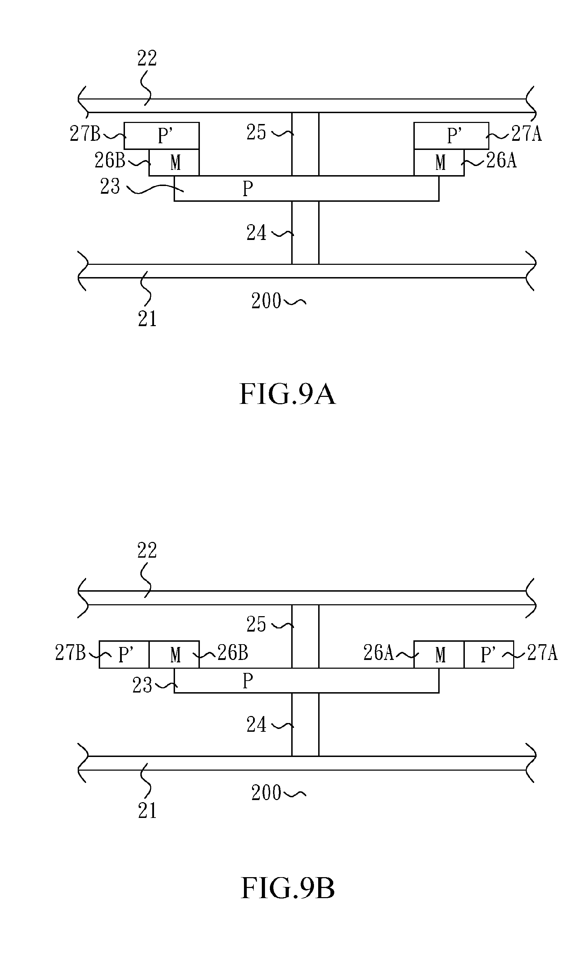

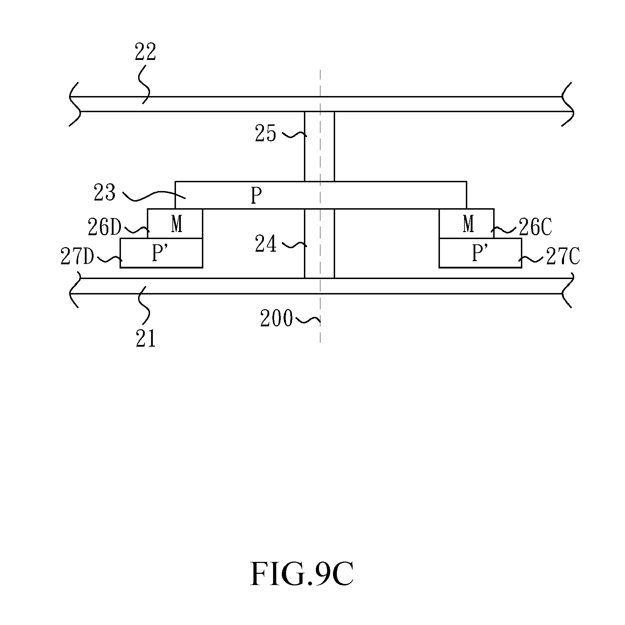

FIG. 9A shows a cross section of a transducer module according to a third embodiment of the present invention. Only the different aspects between the present embodiment and the first/second embodiments are discussed below. In addition to the first transducer 23, the support member 24, the block member 25 and the inertia masses 26A/26B of the second embodiment, the present embodiment further includes at least one second transducer 27A/27B disposed on the inertia masses 26A/26B. The second transducer 27A/27B may be made of the same material of the first transducer 23, or is made of a voice coil motor, an eccentric rotating mass (ERM) motor or a linear resonant actuator (LRA). The second transducers 27A/27B, denoted as P' in FIG. 9A, are fixed on a top surface of the inertia masses 26A/26B, and may be extended outwards. As shown in FIG. 9B, the second transducers 27A/27B are fixed on edge of the inertia masses 26A/26B. As shown in FIG. 9C, the second transducers 27C/27D are fixed on a bottom surface of the inertia masses 26C/26D, and may be extended outwards.

According to the transducer module of the third embodiment, the second transducer 27A-27D may be selectively driven to vibrate when the first transducer 23 has been driven by electric energy. The vibration of the second transducer 27A-27D generates more inertia strength along the central axis 200 passing through the support member 24 and the block member 25. The inertia strength is transferred to the second plate 22, and the transferred inertia strength makes the second plate 22 vibrate and push the air, thereby generating more acoustic effect or haptic feedback. Alternatively, the second transducer 27A-27D may be selectively driven to vibrate in order to increase selectivity of adjusting resonant mode, or to increase swing amplitude of the first transducer 23, thereby enhancing the transferred inertia strength.

Although specific embodiments have been illustrated and described, it will be appreciated by those skilled in the art that various modifications may be made without departing from the scope of the present invention, which is intended to be limited solely by the appended claims.

## Claims

1. A transducer module, comprising:
a first transducer;
a support member, which resists or is fixed on a first plate with a first end, and resists or is fixed on a central section of the first transducer with a second end; and
a block member, which resists or is fixed on the central section of the first transducer with a first end, and resists or is fixed on a second plate with a second end.

2. The transducer module of claim 1, wherein the support member or the block member is embedded in the first plate or the second plate respectively.

3. The transducer module of claim 1, wherein the first plate or the second plate is a screen, a touch panel, a frame, a substrate or a housing.

4. The transducer module of claim 1, wherein the first transducer is made of piezoelectric material, electro-active polymer (EAP) or shape memory alloy (SMA).

5. The transducer module of claim 4, wherein the piezoelectric material is lead-zirconate-titanate (PZT).

6. The transducer module of claim 1, further comprising at least one inertia mass, fixed on an outer section of the first transducer.

7. The transducer module of claim 1, wherein the first transducer comprises:
a conductive layer;
at least one first smart material layer, formed on a top surface of the conductive layer; and
at least one first electrode layer, formed on a top surface of the first smart material layer.

8. The transducer module of claim 7, wherein the conductive layer is a metal plate.

9. The transducer module of claim 7, wherein the first transducer has a rectangular, circular, cross or tri-fork star shape.

10. The transducer module of claim 9, wherein the cross-shape first transducer comprises a cross-shape conductive layer and two first smart material layers that are disposed in cruciform on a top surface of the cross-shape conductive layer, wherein the two first smart material layers are insulated from each other by an insulator.

11. The transducer module of claim 7, wherein the first transducer further comprises:
a second smart material layer, formed on a bottom surface of the conductive layer; and
a second electrode layer, formed on a bottom surface of the second smart material layer.

12. The transducer module of claim 1, wherein the support member comprises a damper.

13. The transducer module of claim 12, wherein the damper is an elastic member, a spring or an elastic rubber.

14. The transducer module of claim 1, wherein at least one second recess is formed on at least one side of the second plate near the block member, such that the first transducer vibrates in a cavity defined by the second recess.

15. The transducer module of claim 14, wherein the block member and the second recess are integrally formed when the second plate is being manufactured, or are formed after the second plate has been manufactured.

16. The transducer module of claim 1, wherein at least one first recess is formed on at least one side of the first plate near the support member, such that the first transducer vibrates in a cavity defined by the first recess.

17. The transducer module of claim 16, wherein the support member and the first recess are integrally formed when the first plate is being manufactured, or are formed after the first plate has been manufactured.

18. The transducer module of claim 6, further comprising:
at least one second transducer, fixed on the inertia mass.

19. The transducer module of claim 18, wherein the second transducer is fixed on a top surface, a bottom surface or an edge of the inertia mass.

20. The transducer module of claim 19, wherein the second transducer is made of piezoelectric material, electro-active polymer (EAP), shape memory alloy (SMA), a voice coil motor, an eccentric rotating mass (ERM) motor or a linear resonant actuator (LRA).
